# EUROPEAN PATENT SPECIFICATION

(11) **EP 4 071 786 B1**
(45) Date of publication and mention of the grant of the patent: **05.11.2025**
(21) Application number: 21166967.6
(22) Date of filing: 06.04.2021
(51) Int. Cl.: H01L 21/28, H01L 21/265, H10D 30/66, H10D 30/01, H10D 64/62, H10D 30/63, H10D 62/834, H10D 64/27, H10D 62/832

(54) **METHOD FOR FORMING AN OHMIC CONTACT ON A WIDE-BANDGAP SEMICONDUCTOR DEVICE AND WIDE-BANDGAP SEMICONDUCTOR DEVICE**
VERFAHREN ZUR FORMUNG EINES OHMSCHEN KONTAKTS AUF EINEM HALBLEITERBAUELEMENT MIT BREITER BANDLÜCKE UND HALBLEITERBAUELEMENT MIT BREITER BANDLÜCKE
PROCÉDÉ DE FORMATION D'UN CONTACT OHMIQUE SUR UN SEMI-CONDUCTEUR À BANDE LARGE ET DISPOSITIF À SEMI-CONDUCTEUR À BANDE LARGE

(43) Date of publication of application: 12.10.2022
(73) Proprietor: Hitachi Energy Ltd, 8050 Zürich (CH)
(72) Inventor: SUNDARAMOORTHY, Vinoth, 5430 Wettingen (CH); KNOLL, Lars, 5607 Hägglingen (CH); WIRTHS, Stephan, 8800 Thalwil (CH)
(74) Representative: Epping - Hermann - Fischer

(56) References cited:
- WO-A1-2019/146300
- CN-B- 102 244 099
- US-A- 3 689 993
- US-A1- 2004 171 204
- US-A1- 2012 061 682
- US-A1- 2013 062 624
- US-A1- 2014 183 561
- SHRESTHA NEELU ET AL: "Low Energy Ion Implantation and Annealing of Au/Ni/Ti Contacts to n-SiC", MRS ADVANCES, vol. 2, no. 51, 1 October 2017 (2017-10-01), pages 2903 - 2908, XP055841767, Retrieved from the Internet <URL:https://www.researchgate.net/profile/Patrick-Leech/publication/316835326_Low_Energy_Ion_Implantation_and_Annealing_of_AuNiTi_Contacts_to_n-SiC/links/5a8b9ea0458515b8af965a81/Low-Energy-Ion-Implantation-and-Annealing-of-Au-Ni-Ti-Contacts-to-n-SiC.pdf> DOI: 10.1557/adv.2017.314
- MINASIAN R A: "Power MOSFET dynamic large-signal model", IEE PROCEEDINGS SECTION A A I, GB, vol. 130, no. 2, 1 April 1983 (1983-04-01), pages 73 - 79, XP001290613, ISSN: 0143-7100

## Description

The present disclosure relates to a method for forming an ohmic contact on a wide-bandgap semiconductor device, comprising depositing and annealing a metal material on top of at least one interface region of a wide-bandgap semiconductor material. The present disclosure further relates to a wide-bandgap semiconductor device, comprising a semiconductor body or epitaxial layer comprising a wide-bandgap semiconductor material and at least one ohmic contact region.

A paper by M. W. Cole, P. C. Joshi, and M. Ervin relates to "Fabrication and characterization of pulse laser deposited Ni2 Si Ohmic contacts on n-SiC for high power and high temperature device applications", Journal of Applied Physics 89, 4413 (2001). The authors investigated electrical, structural, compositional, and surface morphological properties of the contacts as a function of annealing temperatures ranging from 700 to 950°C and found that the as-deposited and 700°C annealed contacts were non-Ohmic. Annealing at 950°C yielded excellent Ohmic behavior, an abrupt void free interface, and a smooth surface morphology.

More recently, a paper by V.K. Sundaramoorthy, R.A. Minamisawa, L. Kranz, L. Knoll, G. Alfieri, on the "Formation of Ohmic contacts to n-type 4H-SiC at low annealing temperatures", International Conference on Silicon Carbide and Related Materials, September 2017, reported the formation of Ohmic contacts to n-type 4H-SiC layers at low annealing temperature using dopant segregation technique. This was achieved by implanting the n-SiC epilayer with phosphorous and subsequent activation at 1700 °C.

US 2004/171204 A1 discloses an ohmic contact formation method where an implanted region is annealed before metal deposition.

SHRESTHA NEELU ET AL: "Low Energy Ion Implantation and Annealing of Au/Ni/Ti Contacts to n-SiC",MRS ADVANCES, vol. 2, no. 51, 1 October 2017 (2017-10-01), pages 2903-2908, XP055841767,DOI: 10.1557/ adv.2017.314 discloses an ohmic contact formation method where rapid thermal anneal is carried out after metal deposition.

US 2014/183561 A1 discloses an ohmic contact with a very thin interface layer.

Embodiments of the disclosure relate to improved wide-bandgap semiconductor devices and methods for their manufacturing, which are easy to implement and allow a great flexibility during manufacturing. For example, there is a need for improved manufacturing methods, which allow the formation of ohmic contacts at relatively low temperatures.

According to a first aspect of the disclosure, a method for forming an ohmic contact on a wide-bandgap semiconductor device is provided. The method comprises shallow implanting a dopant through a first surface of the wide-bandgap semiconductor device using an implantation energy of less than 15 keV to form at least one interface region in a wide-bandgap semiconductor material, thermally treating by rapid thermal processing, of the at least one interface region comprising the implanted dopant at a temperature below 1100°C, and, thereafter, depositing a metal material on top of the at least one interface region to form at least one ohmic contact region. Optionally, the method further comprises annealing the deposited metal material at an annealing temperature below 700°C.

Among others, the inventors have found that forming of a relatively shallow interface layer by implanting a suitable dopant with an implantation energy of less than 15 keV into a wide-bandgap semiconductor material, which is then thermally treated at a temperature below 1100°C before a metal material is deposited on top of the at least one interface region, allows to avoid altogether or at least significant reduce a temperature for a subsequent annealing step to form an ohmic contact. For example, a phosphorous dose of 10¹⁶/cm² may be implanted at an energy of 5 keV into silicon carbide (SiC) and then briefly activated at 1000°C, before Nickel is deposited on the doped surface to form an ohmic contact.

The relatively low implantation energy makes sure that the dopant is implanted only in a relatively thin interface region, resulting in a high local concentration, which enables carrier segregation. This in turn allows to perform further processing steps and to form additional layers before the contact region is formed, thereby greatly enhancing flexibility of the disclosed manufacturing method.

The inclusion of the optional low temperature annealing step after depositing the metal material may improve or enable the ohmic contact behavior of certain metal materials, for example, titanium carbide (TiC).

In at least one embodiment, the wide-bandgap semiconductor material comprises silicon carbide. In at least one embodiment, the deposited metal material forms at least one contact metal layer without chemically reacting with the wide-bandgap semiconductor material in the at least one interface region. In at least one embodiment, the at least one ohmic contact region formed by the deposited metal material is thicker than the at least one interface region. Contrary to previous silicon carbide based wide-bandgap semiconductor devices, a layer formed by depositing a metal material on a wide-bandgap semiconductor material, such as silicon carbide, does not react with the semiconductor material, for example to form a silicide layer, and instead forms a metal layer, such as a contact metal layer, which may be thicker than any intermedia layers, such as the underlying interface region.

According to at least one embodiment, the first surface corresponds to a top surface of the wide-bandgap semiconductor device and the metal material is deposited on top of the at least one interface region to form the at least one ohmic contact region on the frontside of the wide-bandgap semiconductor device. The method according to the first aspect is particularly useful for frontside processing, as the relatively short and/or low temperature processing steps have a reduced impact on active structures formed at or near the top surface of the wide-bandgap semiconductor device.

According to at least one embodiment, after forming the interface region, further processing steps are carried out for forming specific wide-bandgap semiconductor devices. The disclosed process reduces complexity during semiconductor processing, in that the rapid thermal processing may be performed very early in the processing, e.g. before metal-oxide semiconductor (MOS) processing is carried out, and therefore does not affect any of the further processing steps.

According to at least one embodiment, a frontside processing of the wide-bandgap semiconductor device is performed before forming at least one of the at least one interface region or the at least one ohmic contact region. For example, at least one of an oxide layer or a passivation layer may be formed on the surface of the wide-bandgap semiconductor device before the metal material is deposited. Early frontside processing of the wide-bandgap semiconductor device is enabled, among others, by the complete absence of a contact annealing step or a relatively low annealing temperature, which will not affect other parts of the semiconductor device, for example, a previously formed oxide layer or a passivation layer.

According to at least one embodiment, a backside processing of the wide-bandgap semiconductor device is performed, including a thermal treatment step, which results in the thermal treatment of the interface region. For example, at least one backside contact may be formed on a second surface of the semiconductor device, wherein the forming of the at least one backside contact includes an annealing step, which results in the thermal treatment of the interface region. Some steps typically performed before frontside contacts of a semiconductor device are formed, such as forming a backside contact, may lead to a heating of the semiconductor device during its manufacturing. Such a thermal treatment step may also activate the dopant in the interface region, thus eliminating the need for a separate thermal treatment step regarding the dopant implanted in the interface region. According to a second aspect of the disclosure, a wide-bandgap semiconductor device is disclosed. The semiconductor device comprises a semiconductor body or an epitaxial layer comprising a wide-bandgap semiconductor material, at least one interface region, which is doped and arranged within an implantation layer of the wide-bandgap semiconductor material, the at least one interface region having a first thickness, and at least one ohmic contact region arranged within a contact layer on top of the at least one interface region, the at least one ohmic contact region having a second thickness greater than the first thickness. The first thickness is 50 nm or below.

The at least one ohmic contact region comprises more than 99% metal material.

The wide-bandgap semiconductor device according to the second aspect can be manufactured easily, for example using the manufacturing method according to the first aspect, and combines the advantageous properties of ohmic contacts with the advantageous properties of using a wide-bandgap semiconductor device. For example, the very thin, highly doped interface region arranged within an epitaxial layer of silicon carbide enables ohmic contact behavior without the need for high temperature annealing of a metal contact layer arranged on top of it.

According to at least one embodiment, the wide-bandgap semiconductor device is a trench device comprising at least one trench structure. The at least one interface region and the at least one ohmic contact region are laterally adjacent to the at least one trench structure. In such a semiconductor device, a trench structure may be used to place self-aligned ohmic contact regions next to the trench structure. According to an alternative embodiment, the wide-bandgap semiconductor device is a planar device comprising at least one frontside structure arranged in a layer above the semiconductor body or the epitaxial layer. The at least one interface region and the at least one ohmic contact region are laterally adjacent to the at least one frontside structure. Similarly, in a planar semiconductor device, a frontside structure formed before implantation of the dopant may be used to place self-aligned ohmic contact regions next to the frontside structure, for example in a combined contact and gate layer.

The above manufacturing method according to the first aspect is suitable to form different kinds of power semiconductor devices, for example, a junction barrier Schottky (JBS) diode, a metal insulated semiconductor field-effect transistor (MISFET), a metal oxide semiconductor field-effect transistor (MOSFET), an insulated gate bipolar transistor (IGBT), a junction gate field-effect transistor (JFET), a bipolar junction transistor (BJT) or an accumulation field-effect transistor (ACCUFET), among others.

Features and advantages described in connection with the manufacturing method can be used in these and similar wide-bandgap semiconductor devices.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
Figure 1 shows, in a schematic manner, a wide-bandgap semiconductor device according to an embodiment of the present disclosure.
Figure 2 shows, in a schematic manner, a method for forming contact on a wide-bandgap semiconductor device.
Figure 3 shows I-V characteristics of six different test structures annealed at 1000°C without thermal treatment after implantation.
Figure 4 shows I-V characteristics of six different test structures annealed at 450°C without thermal treatment after implantation.
Figure 5 shows I-V characteristics of six different test structures annealed at 450°C with thermal treatment at 1000°C after implantation.
Figure 6 shows an SIMS analysis of a SiC layer after implantation and before metallization.
Figure 7 shows an SIMS analysis of an ohmic contact annealed at 450°C without prior thermal treatment.
Figure 8 shows an SIMS analysis of an ohmic contact annealed at 450°C after thermal treatment of a dopant at 1000°C.
Figures 9A to 12B show processing steps for forming various wide-bandgap semiconductor trench devices according to embodiments of the disclosure.
Figures 13A to 13F show processing steps for forming a wide-bandgap semiconductor device with a field and mesa structure according to an embodiment of the disclosure.
Figures 14A to 14D show processing steps for forming a planar wide-bandgap semiconductor device according to an embodiment of the disclosure.
Figures 15A and 15B show a TEM image of nickel contacts formed according to embodiments of the disclosure.

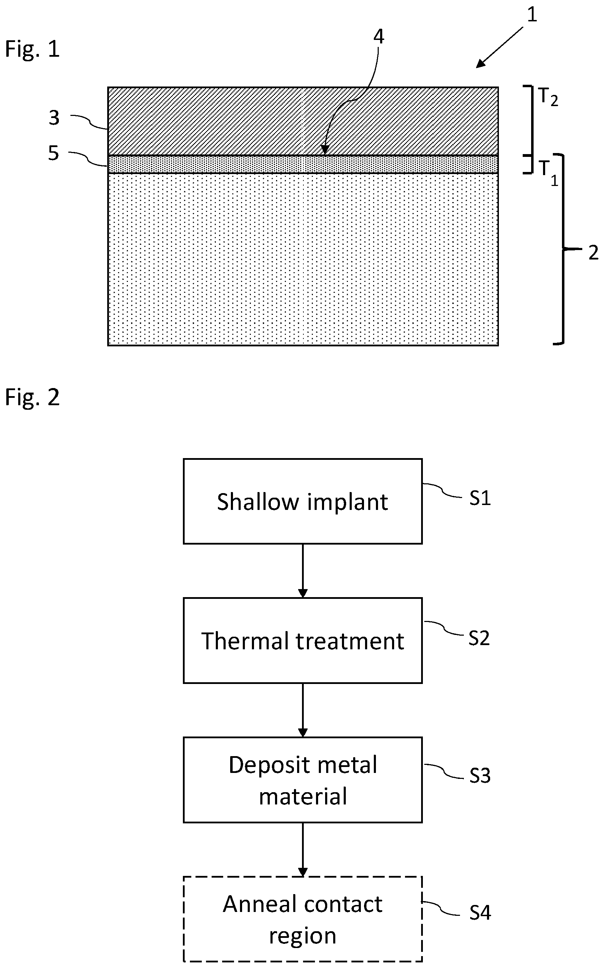

Figure 1 shows a wide-bandgap semiconductor device 1 according to an embodiment of the present disclosure. The wide-bandgap semiconductor device 1 comprises a wide-bandgap semiconductor material 2 and a contact region 3 formed on top of the wide-bandgap semiconductor material 2. For example, the contact region 3 may comprise a metallization feature formed on an upper first surface 4 of at least one of a semiconductor body, for example a substrate, or epitaxial layer (epilayer), comprising the wide-bandgap semiconductor material 2.

As shown in Figure 1, the wide-bandgap semiconductor device 1 comprises a highly doped interface region 5 formed within the wide-bandgap semiconductor material 2 immediately below the contact region 3**.** It should be noted that a first thickness T₁ of the interface region 5 is smaller than a second thickness T₂ of the contact region 3. That is to say, the charge carriers of the dopant defining the highly doped interface region 5 are spatially segregated in a relatively narrow part of the semiconductor material 2. Highly doped in this context means that the concentration of charge carriers of the dopant in the interface region 5 exceeds the charge carriers of the dopant in the wide-bandgap semiconductor material 2 outside the interface region 5 by at least a factor of 10, optionally by a factor of 100.

Such a structure may be formed, for example, using processing steps as detailed below with respect to Figure 2.

In a first processing step S1, a dopant is implanted in a wide-bandgap semiconductor material 2. For example, phosphor ions may be implanted through the first surface 4 at an ion range depth into a silicon carbide epilayer. The implantation may be carried out with a phosphorous dose of 10¹⁶ per cm² at an implantation energy at or below 15 keV, for example 5 keV. In addition to phosphorus (P), other suitable dopants comprise boron (B), arsenic (As), antimony (Sb) and aluminum (Al).

In a subsequent step S2, the implanted dopant is treated thermally. Thermal treatment of the dopant will result in a segregation of the dopant in a very narrow interface region 5. A thickness T₁ of the interface region 5 may be below 50 nm, for example 25 nm.

Sometimes such a thermal treatment step of a dopant is referred to as "activation". However, contrary to conventional activation procedures, the thermal treatment of step S2 may require a lower activation temperature and/or a lower treatment duration. Thus, to avoid any confusion with conventional semiconductor processing steps, one of the terms "thermal treatment" or "short activation" will be used in the following.

After forming the interface region 5, further processing steps may be carried out, not shown in Figure 2 for simplicity, but described later with regard to forming various specific wide-bandgap semiconductor devices 1.

In the method shown in Figure 2, in a step S3, a metal material is deposited on the first surface 4 of the wide-bandgap semiconductor device 1. Any suitable depositing method and material may be used. For example, nickel (Ni), titanium (Ti), aluminum (Al), platinum (Pt), palladium (Pd), cobalt (Co), tungsten (W), tungsten carbide (WC), titanium nitride (TiN), titanium carbide (TiC), tantalum (Ta), tantalum carbide (TaC) or molybdenum (Mo) may be deposited on the top surface 4 of the wide-bandgap semiconductor device 1 using electron beam (e-beam) deposition, sputtering, or chemical vapor deposition (CVD).

In an optional step S4, the contact region 3 comprising the metal material deposited in step S3 may be annealed. Contrary to conventional contact forming procedures, annealing may be omitted, for example, for forming Ni based contacts. For other materials, such as TiC, a relatively low annealing temperature can be used. For example, the metal material deposited on the phosphor implanted interface region 5 may be annealed at a temperature of 450°C to form a metal layer acting as a contact region 3 for an active structure (not shown in Figure 1) previously formed within the wide-bandgap semiconductor device 1.

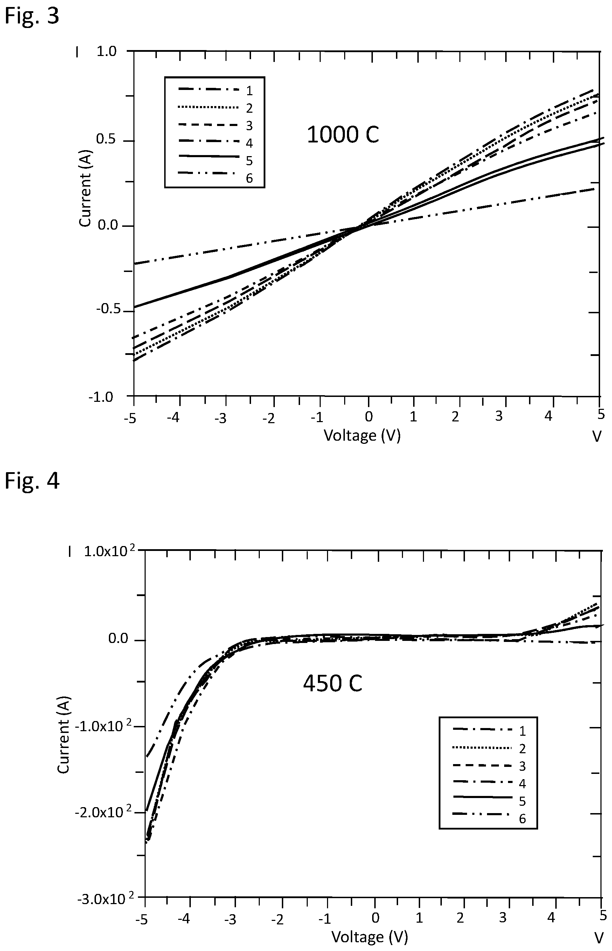

As will be described next, the contact region 3 formed by the above steps has ohmic properties despite the relatively low short activation and/or annealing temperatures. Thus, before individual semiconductor devices and their method for manufacturing will be described later, the impact of various parameters used in the manufacturing process according to Figure 2 will be explained with reference to Figures 3 to 8.

Figure 3 shows the I-V characteristics of six different test structures annealed at an annealing temperature of 1000°C in step S4 in absence of a thermal treatment step S2. As can be seen, annealing a metal material using a relatively high annealing temperature of 1000°C results in a linear I-V characteristic, i.e. an ohmic behavior, of the formed contact region 3.

In general, an ohmic behavior of electrical contact regions 3 is desirable. However, the requirement to heat the metal material deposited in step S3 to a relatively high temperature, i.e. 1000°C, may have negative impacts on other parts formed in or on top of the semiconductor device 1. For example, oxide layers or passivation layers formed to insulate control gates and similar structures of the wide-bandgap semiconductor device 1 may be damaged or at least weakened during such a high temperature annealing step.

Figure 4 shows the I-V characteristics of six similarly formed test structures annealed at a lower temperature of 450°C in step S4. Again, no thermal treatment step S2 was performed between implantation of the dopant in step S1 and annealing of the metal material deposited in step S3. The use of a lower annealing temperature of only 450°C will mitigate negative effects on other parts formed in or on top of the wide-bandgap semiconductor device 1. However, as is evident from Figure 4, the relationship between the current I and the voltage V is non-linear, which will negatively impact the performance of the wide-bandgap semiconductor device 1.

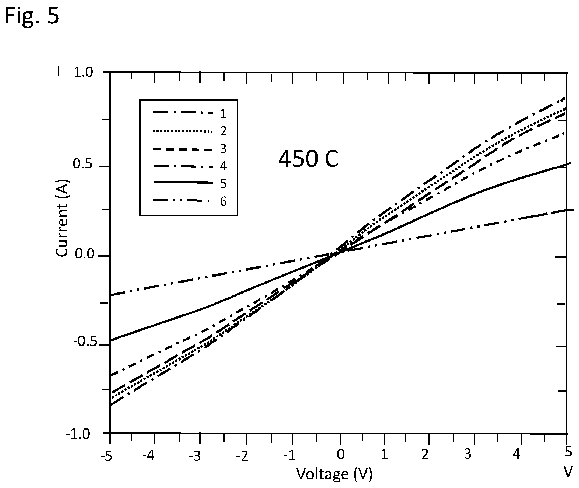

Figure 5 shows the I-V characteristics of six further test structures according to an embodiment of the present disclosure. Specifically, these test structures were thermally treated in step S2 at a temperature of 1000°C after implantation of phosphor in step S1 and before deposition of the metal material in step S3. Then, in a subsequent step S4, the contact region 3 was annealed at a low annealing temperature 450°C. As can be seen in Figure 5, this last group of test structures shows a linear, ohmic response even at the relatively low annealing temperature of 450°C.

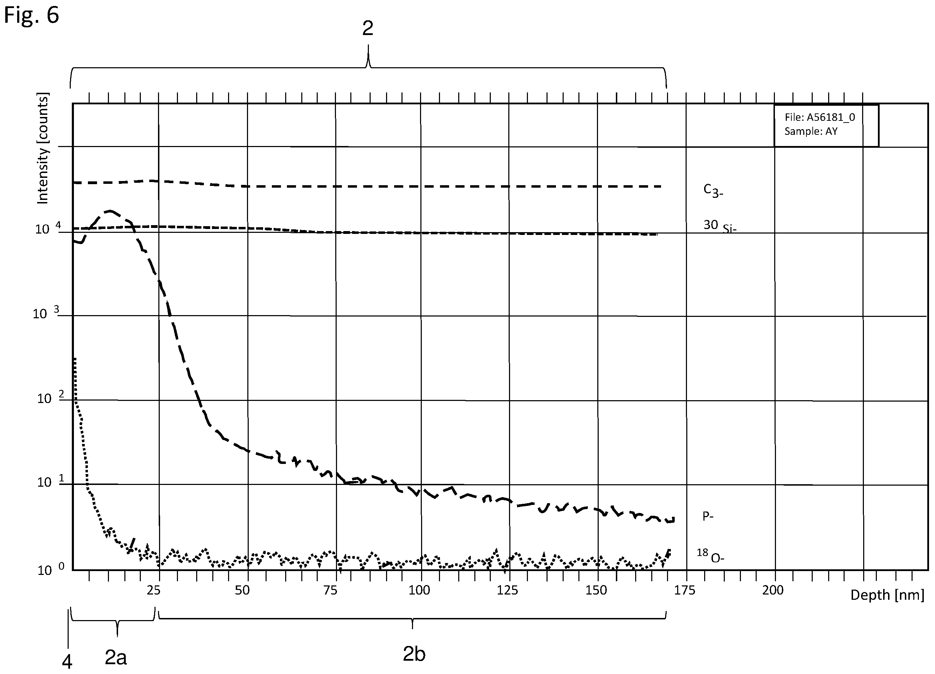

To better explain how the advantageous properties of the test structures according to Figure 5 were achieved, a number of secondary ion mass spectroscopy (SIMS) analyses were performed as shown in Figures 6 to 8.

Figure 6 shows the results of the SIMS analysis after step S2, i.e. after shallow implanting a dopant, for example phosphorus (P-), using a low implantation energy in a top layer of a wide-bandgap semiconductor material 2, such as silicon carbide (SiC). As can be seen, a large proportion of the dopant is present in a relatively thin surface layer 2a of 25 nm thickness close to the first surface 4 of the wide-bandgap semiconductor material 2 corresponding to a depth of 0 nm in Figure 6. A remaining deep layer 2b of the wide-bandgap semiconductor device material 2 remains mostly unaffected by the implanting step. This is achieved, in part, using the relatively low implantation energy of no more than 15 keV, which prevents deep implantation of the dopant into the wide-bandgap semiconductor device material 2. In the example, the boundary between the thin surface layer 2a and the deep layer 2b coincides with the point at which the intensity count of the dopant has dropped to 10% of its maximum. However, other boundary definitions are possible, for example based on a ratio of the average intensity count of the dopant within the layers 2a and 2b, respectively.

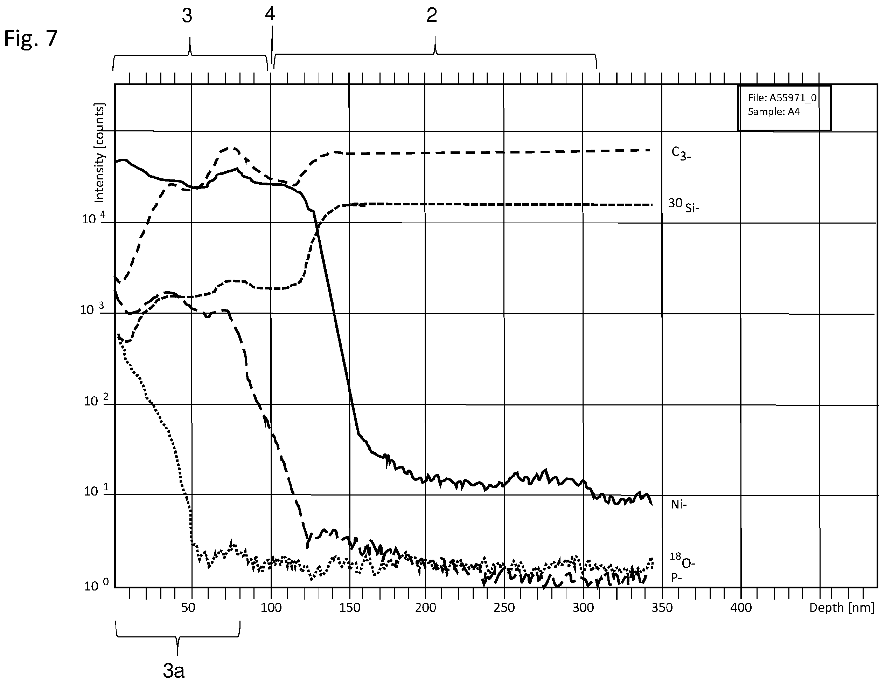

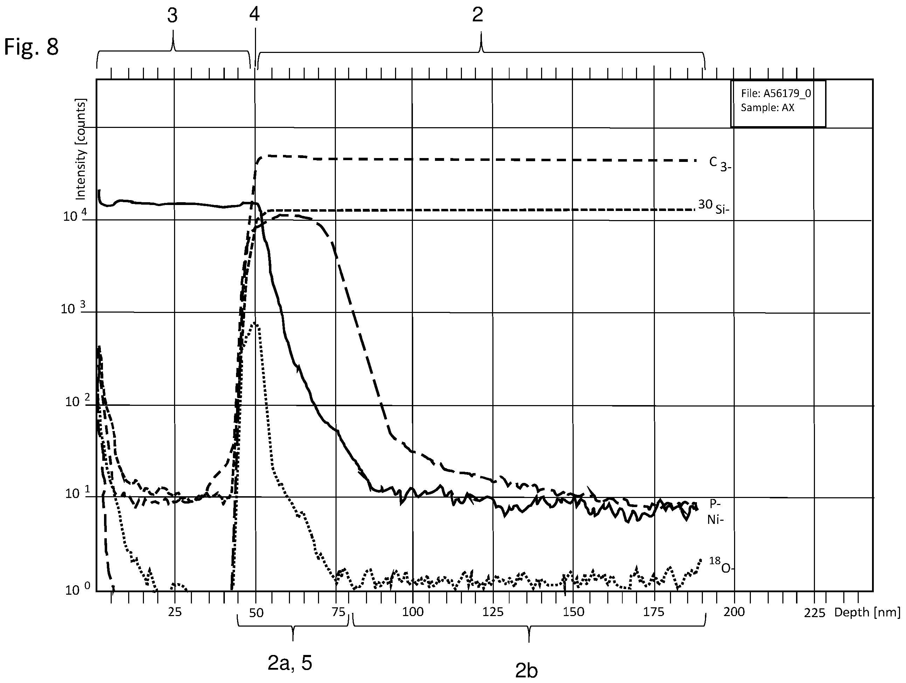

Figures 7 and 8 show the results of two SIMS analysis after forming a contact region 3 on the first surface 4 of the structure as analyzed with regard to Figure 6.

In Figure 7, a layer having a thickness of 100 nm of a metal material, such as Ni, was deposited on the first surface 4 without prior thermal treatment of the highly doped interface region 5. Thus, a contact interface between the contact region 3 and the highly doped wide-bandgap semiconductor device material 2 corresponding to the previous first surface 4 lies at 100 nm in Figure 7. When the metal material was annealed at 450°C in an inert atmosphere on these samples without any heat treatment, the implanted phosphorous dopant moved to a top surface layer 3a of a metal silicide layer formed during depositing of the Nickel and/or annealing. In the analyzed example, an intensity count of phosphorus (P-) at the depth of 100nm is only 20. Hence, the net carrier concentration at the contact interface between the contact region 3 and the wide-bandgap semiconductor material 2 is comparable to that of the original epilayer specification, e.g. the wide-bandgap semiconductor material 2 as-grown or as-received from previous processing steps. Also, some of the silicon (Si-) and carbon (C3-) atoms of the SiC material migrate into the contact region 3. The result is a relatively poor, non-ohmic contact behavior as shown in Figure 4.

The sample shown in Figure 8 was subjected to a short activation process by thermally treating the surface layer 2a of the wide-bandgap semiconductor device material 2 comprising the dopant after performing the implantation step S1 und before depositing a metal material in step S3. When the samples were subjected to a rapid thermal processing (RTP) step at 1000°C in vacuum before a 50 nm nickel layer was deposited and subsequently annealed at 450°C after nickel deposition, the implanted dopants stayed within a narrow interface region 5 corresponding in thickness to the highly doped surface layer 2a formed previously during implanting. Practically no phosphorous is present within the contact region 3 as shown in Figure 8, with the exception of minor traces near the surface. At any rate, in the measured sample, the Phosphorus content throughout the contact layer 3 lies below 1% of the corresponding Nickel concentration. Moreover, only very low concentrations of Si or C atom can be seen in the contact layer 3. That is to say, the contact layer 3 corresponds to a metal contact, comprising more than 99%, in the measured sample more than 99.8%, pure metal. Lastly, contrary to the results shown in Figure 7, a distinct peak in the oxygen (O-) concentration can be seen at the top of the interface region 5. This increases the effective net carrier concentration at the contact interface between the contact region 3 and the wide-bandgap semiconductor material 2, thereby achieving ohmic contacts at the relatively low temperature of 450°C.

The following table shows the specific contact resistance of two different metals, Ni and TiC, found at different annealing temperatures using the method described with respect to Figure 2 on a n-SiC semiconductor layer by shallow implanting a phosphorous dose of 10¹⁶/cm² at 5 keV, thermally treated at 1000°C using RTP.

| Annealing temperature (°C) | Specific electrical contact resistance (Ω·m) | |
|---|---|---|
| | Ni | TiC |
| No annealing | 1.9·10⁻⁵ | - |
| 450 | 2.3·10⁻⁵ | 5.4·10⁻⁵ |
| 550 | 1.9·10⁻⁴ | 1.0·10⁻⁵ |
| 700 | 1.4·10⁻⁴ | - |
| 1000 | 6.0·10⁻⁵ | 1.6·10⁻⁵ |
| 1200 | - | 1.4·10⁻⁵ |

As indicated before, the method disclosed in Figure 2 can be used to achieve ohmic contact behavior without annealing or at low annealing temperatures that will not affect any oxide interface or passivation layer already present in the wide-bandgap semiconductor device 1. Thus, the combination of a shallow implantation with a relatively low implantation energy followed by a thermal treatment or short activation step offers flexibility in the process integration and enables several novel wide-bandgap semiconductor devices, such as SiC device structures. As an additional advantage, novel, low resistive gate metals such as Ti, TiN, TiC or TaN can be integrated to allow for faster switching speeds of fabricated wide-bandgap semiconductor power devices, such as SiC power MOSFETs.

The short activation of the dopant in step S2 can be done after implanting further layers used in the device fabrication process and before the formation of any oxide and/or passivation layers. Then, the ohmic contacts may be formed with no or a low annealing temperature of, for example, 450°C at any later stage of the device fabrication. As a result, severe dopant diffusion in passivation or gate oxide layers can be prevented, which in turn may result in an improved threshold voltage stability of the finished wide-bandgap semiconductor device 1.

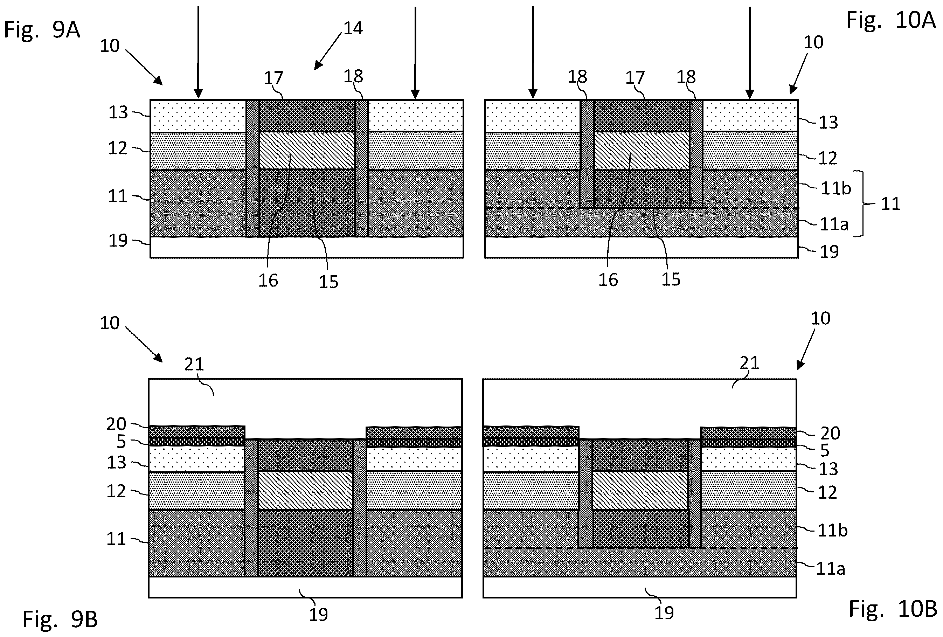

Next, the formation of several specific wide-bandgap semiconductor devices is described in more detail using Figures 9A to 18D.

Figures 9A to 12B show processing steps for manufacturing different semiconductor trench devices.

As an example, four different configurations of an ACCUFET 10 as shown in Figures 9A to 12B are described. The device-specific processing steps required to form the body of the ACCUFET 10 and its backside metallization are not shown for simplicity. Only the procedural steps required for shallow implantation of a dopant as well as doping segregation and metallization are shown in Figures 9A to 12A as well as Figures 9B to 12B, respectively.

Figure 9A shows a semiconductor trench device at an intermediate stage of fabrication.

The example of Figure 9A shows a semiconductor structure of an ACCUFET 10 at a stage before formation of frontside contacts. At this stage, the ACCUFET 10 comprises a n-type SiC layer 11, a p- SiC layer 12 and an n+ SiC layer 13 arranged on top of each other. In a central region of the three layers 11 to 13, a trench structure 14 is formed, for example, by anisotropic etching of the epitaxial layers. In the trench structure 14, a lower SiO₂ insulation area 15, a buried gate 16 and an upper SiO₂ insulation area 17 are formed. Between the three SiC layers 11 to 13 and the gate 16 as well as the SiO₂ insulation areas 15 and 17, a vertical passivation layer 18 is formed on each side of the trench structure 14. For example, an oxide layer is formed to electrically insulate the trench structure 14 from the surrounding SiC material.

In the finished ACCUFET 10, the top n+ type SiC layer 13 serves as a source area, the middle p- type SiC layer 12 serves as a channel area and the bottom n-type SiC layer 11 serves as a drain area of the ACCUFET 10. The buried gate 16 enables or disables conduction in the middle p- type SiC layer 12 serving as a channel area of the ACCUFET 10.

In the situation depicted in Figure 9A, a backside metallization in the form of a drain contact 19 has already been formed on a lower surface of the n-type SiC layer 11. In other words, both the formation of the active areas of the semiconductor device as well as back side processing has been completed. At this stage, a shallow implantation of a dopant takes place on the opposite surface of the stack of epilayers 11 to 13, i.e. at the top surface of the n+ type SiC layer shown in Figure 9A. For example, phosphorous or a similar dopant may be implanted using a relatively low implantation energy of 5 keV.

This implantation layer is then thermally treated for a short period of time, for example at a temperature of 1000°C for a duration of five minutes, to achieve doping segregation as shown in Figure 9B. As a result, a relatively thin interface region 5 is formed in a top layer of the n+ type SiC layer 13. Thereafter, a metal material is deposited on the top surface of the semiconductor structure. As a result, an ohmic metal contact 20 is formed on the top surface of the interface region 5, as also depicted in Figure 9B.

Attention is drawn to the fact that the presence of the trench structure 14 previously formed in the ACCUFET 10 leads to a self-alignment of the formed ohmic metal contacts 20. During the shallow implantation step shown in Figure 9A, no interface region with a high dopant concentration is formed in the central area of the ACCUFET 10 due to the chemical properties of the material used to form the passivation layers 18 and the upper SiO₂ insulation area 17. Similarly, no deposition of metal takes place in the central area corresponding to the trench structure 14. Consequently, no separate masking procedure is required to form the ohmic metal contacts 20. At the same time, an alignment of the ohmic metal contacts 20 with the underlying n+ type SiC layer 13 serving as source is enabled, allowing the manufacturing of trench semiconductor devices with a narrow cell pitch.

In a further step, a frontside metallization serving as a source contact 21 may be formed over the entire width of the ACCUFET 10, electrically connecting the two ohmic metal contacts 20 with a source potential. Note that the source contact 21 is electrically isolated from the buried gate 16 by the insulation area 17 and the passivation layers 18.

In the ACCUFET 10 shown in Figures 9A and 9B, the trench structure extends all the way from the frontside metallization to the backside metallization, i.e. through the entire height of the epilayers 11 to 13. However, similar processing steps may also be performed on the semiconductor trench device shown in Figures 10A and 10B.

The ACCUFET 10 shown in Figures 10A and 10B differs from the structure described above with respect to Figures 9A and 9B in that the trench structure 14 does not extend all the way to the backside metallization 19. Instead, the trench structure 14 extends through the top n+ type SiC layer 13, the p- type SiC layer 12 and ends within the n-type SiC layer 11. Accordingly, the n-type SiC layer 11 comprises an uninterrupted body portion 11a and two interrupted side portions 11b.

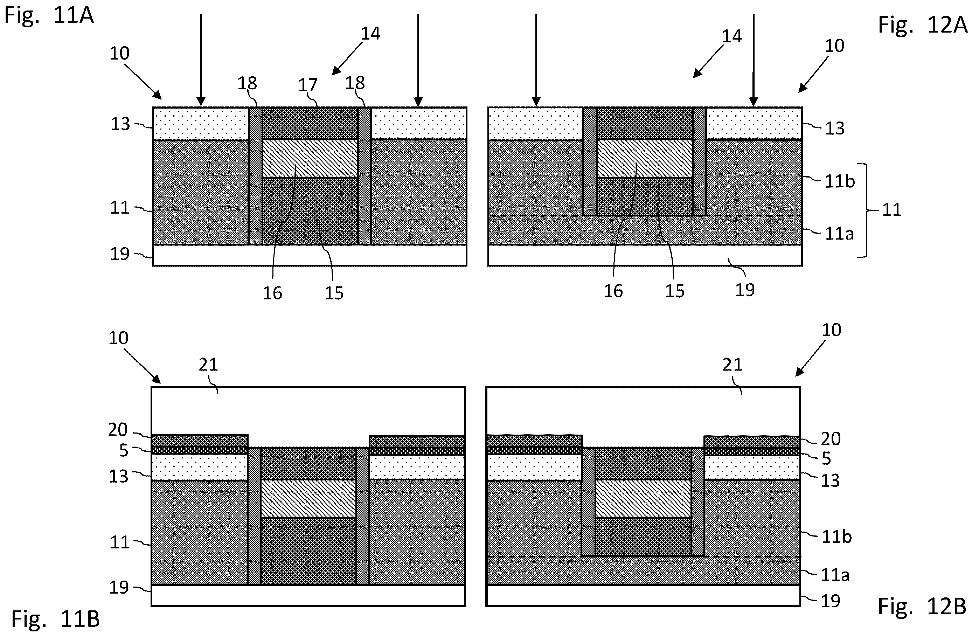

Figures 11A and 11B shows a third semiconductor trench device in the form of a further ACCUFET 10. Contrary to the ACCUFET 10 shown in Figures 9A and 9B, the ACCUFET 10 of Figure 11A only comprises a lower n-type SiC layer 11 and an upper n+ type SiC layer 13. In this configuration, the lower n-type SiC layer 11 serves both as an emitter area in a lower portion laterally adjacent to the lower SiO₂ insulation area 15 as well as a channel area an upper portion laterally adjacent to the gate 16. Otherwise, the setup and the manufacturing of the ACCUFET 10 shown in Figures 11A and 11B corresponds to that of the ACCUFET 10 described above with regard to Figures 9A and 9B.

Figures 12A and 12B show a fourth semiconductor trench device in the form of a further ACCUFET 10. Like the ACCUFET 10 shown in Figures 11A and 11B, the ACCUFET shown in Figures 12A and 12B only comprises a lower n-type SiC layer 11 serving as both an emitter area and a channel area as well as an upper n+ type SiC layer 13. Moreover, as described above with regard to Figures 10A and 10b, the trench structure 14 does not extend all the way through the epitaxial layers 11 and 13 but only to a certain channel depth, which divides the lower n-type SiC layer 11 in an uninterrupted body portion 11a and two interrupted side portions 11b.

In all embodiments shown in Figures 9A to 12B, the ohmic metal contacts 20 of the source areas of the ACCUFET 10 can be made by self-alignment. Since the ohmic metal contacts 20 are annealed at low temperatures, they can be formed most of the full front processing of the ACCUFET 10 is finished. For example, as described above, the passivation layer 18, the SiO₂ insulation areas 15 and 17 and the buried gate 16 can be formed prior to forming the metal contacts 20.

Moreover, the contacts 20 to the source areas and a contact to the buried gate 16 (not shown in Figures 9A to 12B) are formed at the same time, thereby allowing narrow cell pitches to be formed without requiring a separate lithographic step. The typical cell pitch, e.g. the width of source and gate regions of the ACCUFETs 10 shown in Figures 9A to 12B, are in the range from 1.5 to 3 µm. The widths of the source and gate contacts range from 0.75 µm to 1.5 µm. Without the described self-alignment, it would be difficult to form ohmic contacts 20 to these terminals by standard lithographic alignment processes. However, due to the improved flexibility in processing the ACCUFET 10, the ohmic contacts 20 can be formed by self-alignment after forming the relatively thin vertical passivation layers 18 on the sidewalls of the trench structure 14. As the annealing is performed at a relatively low annealing temperature of below 450°C, there is less of a chance to form a short circuit between the source and gate regions.

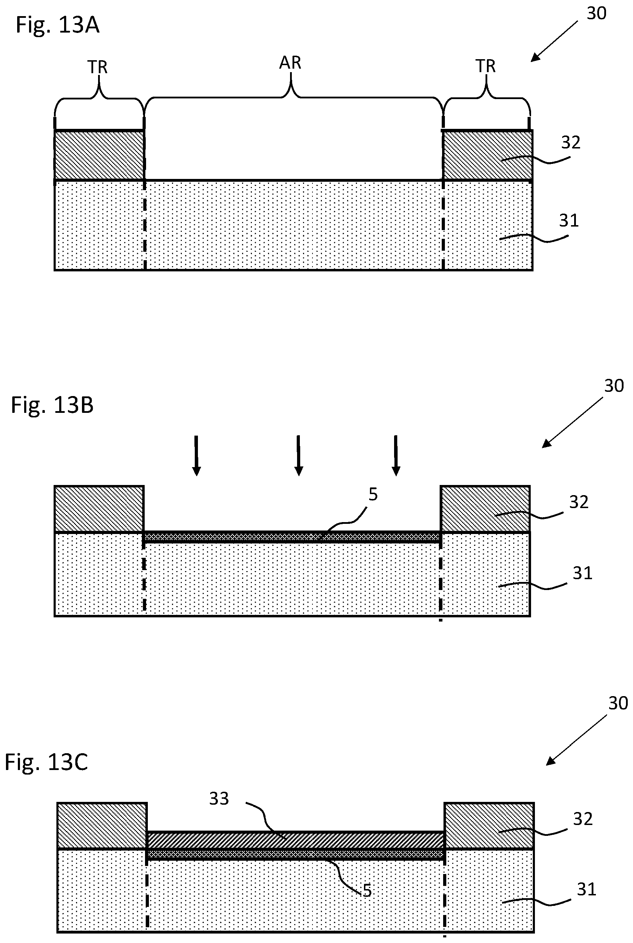

Figures 13A to 13 F show another embodiment of a wide-bandgap semiconductor device. The embodiment shows that it is possible to form essentially implantation and activation free semiconductor devices 1 using a combination of the method described above for forming segregated ohmic contacts with an approach for edge termination design using a field plate and mesa structure as disclosed, for example, in European patent application EP 3 416 184 A1.

In the semiconductor device disclosed in EP 3 416 184 A1, implantation and high temperature activation in excess of 1600°C are employed to form highly doped regions for ohmic contact formation and p-doped termination regions in a SiC device. However, implantation involving high energy doses usually causes a so-called strangling effect in the SiC semiconductor material, thereby affecting a background doping in neighboring regions. Furthermore, a high temperature activation of the doped area causes step bunching on the SiC material surface, affecting the device properties. However, if ohmic contacts are formed by dopant segregation as detailed above, these effects can be avoided or at least be mitigated.

Figure 13A shows a masking step for manufacturing a semiconductor device 30 with a so-called mesa structure. At this stage, the semiconductor device 30 comprises only a SiC layer 31, for example a SiC substrate or SiC epitaxial layer. To form the actual mesa structure, a photoresist mask 32 is placed in a termination region TR of the semiconductor device 30. In contrast, an active region AR is left uncovered by the photoresist mask 32.

Thereafter, a dopant is implanted and thermally treated at a temperature below 1100°C in a shallow interface region 5 as detailed above. Note that the interface region 5 is limited to the exposed active region AR as shown in Figure 13B.

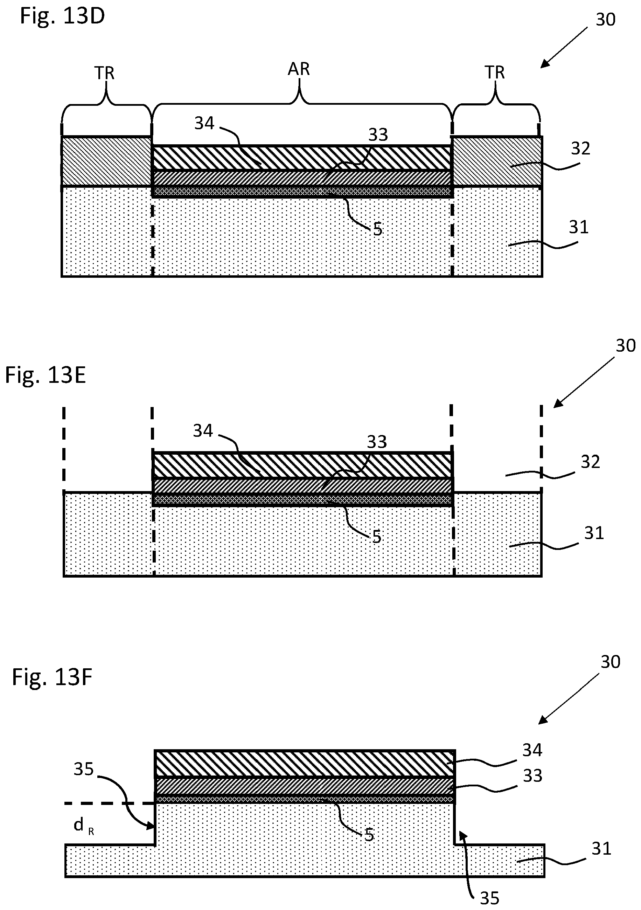

In two subsequent steps, shown in Figures 13C and 13D, respectively, first a contact metal layer 33 and then a frontside electrode layer 34 is deposited on the interface region 5. Due to the carrier segregation in the interface region 5, neither the metal material from the contact metal layer 33 nor that of the frontside electrode layer 34 reacts with the semiconductor material of the SiC layer 31. While the schematic drawings of Figures 13A to 13F are not to scale, attention is drawn to the fact that the interface region 5 is thinner than each one of the contact metal layer 33 and the frontside electrode layer 34. Moreover, in the depicted embodiment, the contact metal layer 33 is thinner than the frontside electrode layer 34.

In a next step shown in Figure 13E, the photoresist mask 32 is removed from the SiC layer 31, exposing the semiconductor material of the SiC layer 31 in the termination region TR. Note that the semiconductor material of the SiC layer 31 in the active region AR is covered by the contact metal layer 33 and the frontside electrode layer 34 at this stage.

Thus, in an anisotropic etching step, the frontside electrode layer 34 effectively acts as a mask, alleviating the need for a further photolithographic processing step. This is achieved by a selectivity of a used etchant, which etches the semiconductor material of the SiC layer 31 in the termination region TR, but does not remove a significant part of the metal material of the frontside electrode layer 34.

Consequently, a recess 35 is formed in the termination region TR as shown in Figure 13F. The recess 35 has a depth d_{R} with respect to the top surface of the SiC layer 31 or the bottom surface of the contact metal layer 33. The recess 35 in the termination region TR forms a mesa edge termination structure in the final power semiconductor device 30.

As shown in Figure 13F, the termination region TR is formed using a combination of a field plate and mesa region, which is an effective termination, for example for semiconductor devices 30 for a voltage of up to 1.7 kV or above. Therefore, it is possible to achieve a low voltage ACCUFET structure without high energy dose implantation and high temperature activation by using dopant segregated ohmic contacts and mesa termination as shown in Figures 13A to 13F.

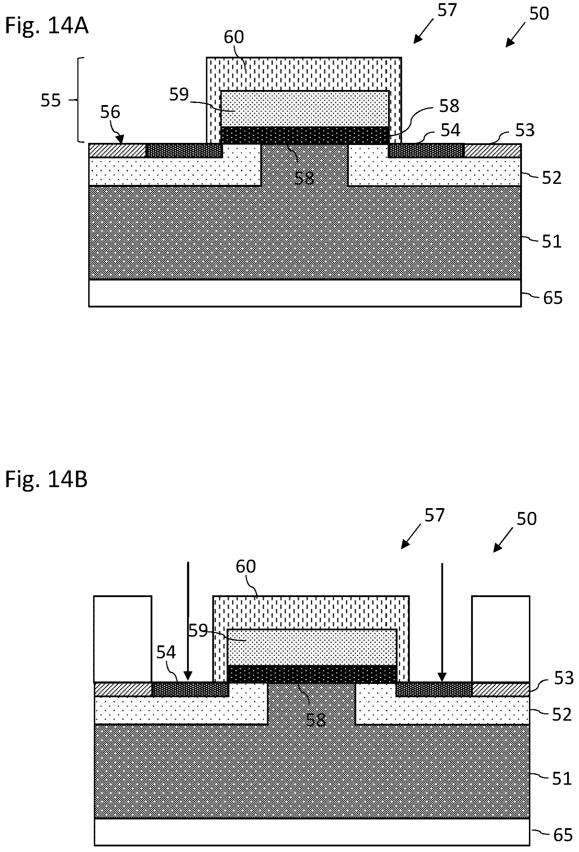

Figures 14A to 14D show four processing steps in the formation of a planar semiconductor device with a frontside structure. As an example, processing of a MOSFET 50 is shown.

In the stage shown in Figure 14A, most of the device-specific features within the semiconductor material of the MOSFET 50 have already been formed. In the described embodiment, the MOSFET 50 comprises an n-type SiC layer 51 including a channel region of the MOSFET 50, and two laterally spaced apart p- type SiC areas 52. Within each of the p- type SiC areas 52, an outer p+ SiC area 53 and an inner n+ SiC area 54 are formed. The areas 53 and 54 will act as a source of the completed MOSFET 50. Moreover, a backside metallization serving as a drain electrode 65 has already been formed on a lower surface of the n-type SiC layer 51.

In a contact and gate layer 55 above a top surface 56 of the epitaxial layer 51 and active areas 52 to 54, a frontside structure 57 is formed. In the depicted embodiment, the frontside structure 57 comprises a passivation layer 58 formed over the channel region of the MOSFET 50, a metal gate 59 and a gate insulation 60 formed, for example, from SiO₂.

Before an actual source contact is formed on the frontside of the semiconductor structure shown in Figure 14A, a dopant is implanted in a shallow surface area of the inner n+ SiC areas 54 as shown in Figure 14B. For this purpose, the outer p+ SiC areas 53 are covered with a photoresist mask 61. Note that the photoresist mask 61 may slightly overlap with the inner n+ SiC area 54. Moreover, a vertical insulation area of the gate insulation 60 of the frontside structure 57 may also partially overlap with the inner n+ SiC area 54. Further note that the gate insulation 60 does not need to be masked separately, but serves as mask in the shallow implantation itself. Consequently, only a central part of the inner n+ SiC area 54 will be exposed to the species used for shallow implantation.

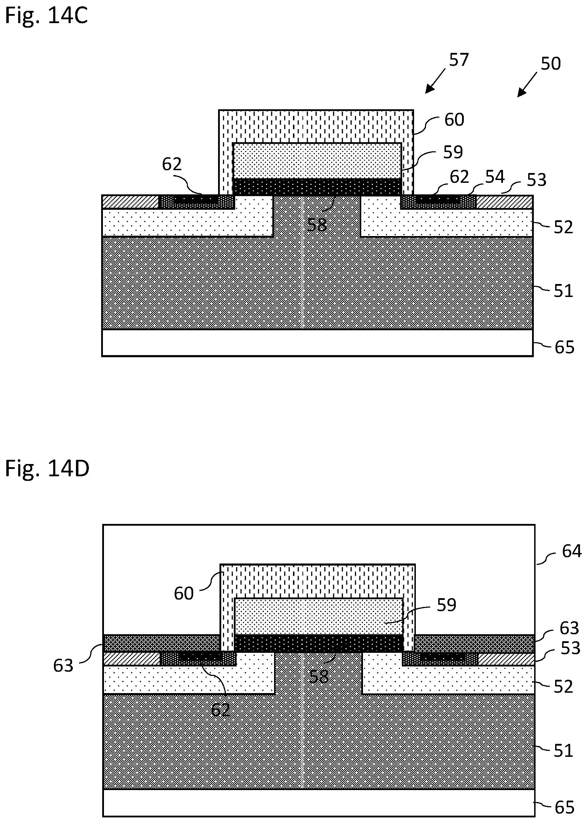

Consequently, a highly doped area 62 acting as interface region 5 is formed only within the inner n+ SiC area 54 as shown in Figure 14C. At least in this area, an ohmic contact will be formed between an ohmic metal contacts 63 and the underlying p- type SiC area corresponding to the source area as shown in in Figure 14D. Figure 14D also shows that a metal source electrode 64 encapsulating the entire front face of the MOSFET 50 is formed over the ohmic metal contacts 63 and the gate insulation 60 of the frontside structure 57.

Note that, in this embodiment, the frontside structure 57 serves to align the highly doped area 62 during shallow implantation. Accordingly, planar semiconductor devices with a very narrow pitch structure can be formed. The ohmic contacts 63 can be formed after the frontside processing of the MOSFET including forming of a dielectric passivation layer 58 and the gate insulation 60 has been completed. This allows the alignment of source contacts, which are placed close to the edge of terminals a gate structure, without having to allow spacing for a lithographic alignment. This helps to achieve high cell density and better on-state performance of the formed MOSFET 50.

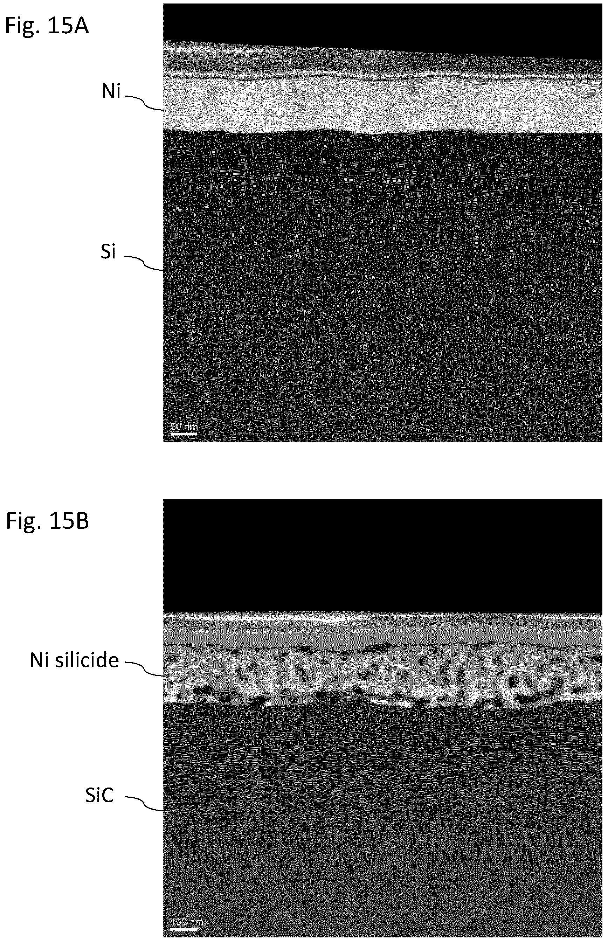

Figures 15A and 15B show two images obtained by transmission electron microscopy (TEM) on electrical contacts formed by depositing nickel on a silicon carbide wide-bandgap semiconductor material 2 using dopant segregation as detailed above.

Figure 15A shows a Ni contact annealed at a relatively low annealing temperature of 450°C. The Ni contact layer formed in this way has a very smooth Ni interface over an essentially undisturbed underlying SiC layer. It can be seen that the formed Ni metal layer is monocrystalline and does not react with the underlying, highly doped SiC material at an annealing temperature at 450°C.

Figure 15B shows a Ni contact annealed at a relatively high annealing temperature of 1000°C. Contrary to the contact shown in Figure 15A, the contact annealed at a temperature of 1000°C has a rougher morphology. For example, a relatively high proportion of nickel silicide is formed at an interface layer, disturbing the below SiC material.

The analysis of the formed contact shows that the low annealing temperature of 450°C is not only sufficient to form ohmic contacts, but actually results in an improved crystalline structure of the formed contact. In contrast, a higher annealing temperature of 1000°C is detrimental to the formed contacts.

The embodiments shown in the Figures 1, 2 and 9A to 14D as stated represent exemplary embodiments of the improved semiconductor devices and method for their manufacture. Therefore, they do not constitute a complete list of all embodiments according to the improved semiconductor circuit devices and manufacturing methods. Actual devices and methods may vary from the embodiments shown in terms of specific arrangements, devices, and materials for example.

### Reference Signs

- 1: wide-bandgap semiconductor device
- 2: wide-bandgap semiconductor device material
- 2a: surface layer
- 2b: deep layer
- 3: contact region
- 3a: top surface layer
- 4: first surface
- 5: interface region

- 10: ACCUFET
- 11: n-type SiC layer
- 11a: uninterrupted body portion
- 11b: interrupted side portion
- 12: p- type SiC layer
- 13: n+ type SiC layer
- 14: trench structure
- 15: (lower SiO₂) insulation area
- 16: (buried) gate
- 17: (upper SiO₂) insulation area
- 18: (vertical) passivation layer
- 19: drain contact
- 20: ohmic metal contact
- 21: source contact

- 30: semiconductor device (with mesa structure)
- 31: SiC layer
- 32: photoresist mask
- 33: contact metal layer
- 34: frontside electrode layer

- 35: recess

- 50: MOSFET
- 51: n-type SiC layer
- 52: p- type SiC area
- 53: (outer) p+ SiC area
- 54: (inner) n+ SiC area
- 55: (contact and gate) layer
- 56: top surface
- 57: frontside structure
- 58: passivation layer
- 59: metal gate
- 60: gate insulation
- 61: photoresist mask
- 62: highly doped area
- 63: ohmic metal contact
- 64: source electrode
- 65: drain electrode

- d_{R}: depth of recess

- AR: active region
- TR: termination region

- T₁: first thickness
- T₂: second thickness

- S1-S4: processing steps

## Claims

1. A method for forming an ohmic contact on a wide-bandgap semiconductor device (1), comprising:
- shallow implanting a dopant through a first surface (4) of the wide-bandgap semiconductor device (1) using an implantation energy of less than 15 keV to form at least one interface region (5) in a wide-bandgap semiconductor material (2);
- rapid thermal processing of the at least one interface region (5) comprising the implanted dopant at a temperature below 1100°C;
- after rapid thermal processing of the at least one interface region (5), depositing a metal material on top of the at least one interface region (5) to form at least one ohmic contact region (3); and
- optionally annealing the deposited metal material at an annealing temperature below 700°C.

2. The method of claim 1, wherein shallow implanting is performed with an implantation energy at or below 5 keV.

3. The method of any one of claims 1 or 2, wherein at least one of
- shallow implanting the dopant comprises implanting the dopant into the wide-bandgap semiconductor material (2) using a dose between 10¹⁴/cm² and 10¹⁸/cm²;
- the wide-bandgap semiconductor material comprises silicon carbide;
- the deposited metal material forms at least one contact metal layer (33) without chemically reacting with the wide-bandgap semiconductor material (2) in the at least one interface region (5); or
- the at least one ohmic contact region (3) formed by the deposited metal material is thicker than the at least one interface region (5).

4. The method of any one of claims 1 to 3, further comprising at least one of the following:
- performing a front-side processing of the wide-bandgap semiconductor device (1) before forming at least one of the at least one interface region (5) or the at least one ohmic contact region (3); or
- forming at least one of an oxide layer or a passivation layer (58) before depositing the metal material.

5. The method of any one of claims 1 to 4, further comprising at least one of the following:
- performing a backside processing of the wide-bandgap semiconductor device (1), wherein the backside processing includes a thermal treatment step, which results in the thermal treatment of the interface region (5); or
- forming at least one backside contact on a second surface of the semiconductor device (1), wherein forming the at least one backside contact includes an annealing step, which results in the thermal treatment of the interface region (5).

6. The method of any one of claims 1 to 5, further comprising:
- forming at least one trench structure (14) within the wide-bandgap semiconductor material (2) or forming a frontside structure (57) on the first surface (4); and
- using the at least one trench structure (14) or the frontside structure (57), respectively, to laterally self-align the at least one interface region (5) and/or the at least one ohmic contact region (3).

7. The method of any one of claims 1 to 6, further comprising:
- etching the wide-bandgap semiconductor material (2) to form at least one recess (35), wherein at least one of the at least one ohmic contact region (3) or a frontside electrode layer (34) formed on a third surface of the at least one contact region (3) serves as an etching mask.

8. A wide-bandgap semiconductor device (1), comprising:
- a semiconductor body or an epitaxial layer comprising a wide-bandgap semiconductor material (2);
- at least one interface region (5), which is doped and arranged within a shallow implantation layer of the wide-bandgap semiconductor material (2), the at least one interface region (5) having a first thickness (T₁) below 50 nm; and
- at least one ohmic contact region (3) comprising more than 99% metal material arranged within a contact layer on top the at least one interface region (5), the at least one ohmic contact region (3) having a second thickness (T₂) greater than the first thickness (T1);
**characterised in that** a distinct peak in the oxygen (0-) concentration can be seen at the top of the interface region (5).

9. The wide-bandgap semiconductor device (1) of claim 8, further comprising at least one active region arranged within the wide-bandgap semiconductor material (2), the at least one active region having a third thickness, wherein at least one of
- the third thickness is greater than at least one of the first thickness (T₁) or the second thickness (T₂); or
- the at least one doped interface region (5) has a higher dopant concentration than the at least one active region; or
- a dopant material of the at least one active region differs from a dopant material of the at least one interface region (5).

10. The wide-bandgap semiconductor device (1) of claim 8 or 9, wherein the wide-bandgap semiconductor device (1) is a trench device comprising a trench structure (14), and the at least one interface region (5) and the at least one ohmic contact region (3) are laterally adjacent to the at least one trench structure (14).

11. The wide-bandgap semiconductor device (1) of claim 10, wherein the at least one trench structure (14) comprises a buried gate (16), an insulation area (17) arranged on top of the buried gate (16), and at least one vertical passivation layer (18) arranged laterally between the insulation area (17) and the at least one interface region (5).

12. The wide-bandgap semiconductor device (1) of claim 8 or 9, wherein the wide-bandgap semiconductor device (1) is a planar device comprising at least one frontside structure (57) arranged in a layer (55) above the semiconductor body or the epitaxial layer, and wherein the at least one interface region (5) and the at least one ohmic contact region (3) are laterally adjacent to the at least one frontside structure (57).

13. The wide-bandgap semiconductor device (1) of claim 12, wherein the at least one frontside structure comprises a metal gate (59) and a gate insulation (60), the gate insulation (60) comprising a horizontal insulation area arranged on a top surface of the metal gate (59) and a vertical insulation area arranged on at least one side surface of the metal gate (59), the at least one vertical insulation area arranged laterally between the metal gate (59) and at least one ohmic contact region (3).

14. The wide-bandgap semiconductor device (1) of any one of claims 8 to 13, wherein at least one of
- the wide-bandgap semiconductor material (2) comprises a silicon carbide material of a silicon carbide wafer or a silicon carbide epitaxial layer; or
- the at least one interface region (5) comprises at least one of implanted phosphor ions, implanted boron ions, implanted arsenic ions, implanted antimony ions and implanted aluminum ions; or
- the at least one ohmic contact region (3) comprises at least one of nickel, titanium, aluminum, platinum, palladium, cobalt, tungsten, tungsten carbide, titanium nitride, titanium carbide, tantalum, tantalum carbide or molybdenum.

15. The wide-bandgap semiconductor device (1) of any one of claims 8 to 14, wherein the semiconductor device (1) is a power semiconductor device, comprising one of a Junction Barrier Schottky diode, a Metal Insulated Semiconductor Field Effect Transistor, a Metal Oxide Semiconductor Field Effect Transistor (50), an Insulated-Gate Bipolar Transistor, a Junction-gate Field Effect Transistor, a Bipolar Junction Transistor, or an Accumulation Field Effect Transistor (10).

## Patentansprüche

1. Verfahren zum Ausbilden eines ohmschen Kontakts auf einem Halbleiterbauelement (1) mit breiter Bandlücke, Folgendes umfassend:
- flaches Implantieren eines Dotierstoffs durch eine erste Oberfläche (4) des Halbleiterbauelements (1) mit breiter Bandlücke unter Verwendung einer Implantationsenergie von weniger als 15 keV, um mindestens einen Grenzbereich (5) in einem Halbleitermaterial (2) mit breiter Bandlücke auszubilden;
- schnelles thermisches Verarbeiten des mindestens einen Grenzbereichs (5), der den implantierten Dotierstoff umfasst, bei einer Temperatur unter 1100 °C;
- nach schnellem thermischem Verarbeiten des mindestens einen Grenzbereichs (5), Aufbringen eines Metallmaterials auf der Oberseite des mindestens einen Grenzbereichs (5), um mindestens einen ohmschen Kontaktbereich (3) auszubilden; und
- optionales Tempern des aufgebrachten Metallmaterials bei einer Tempertemperatur unter 700 °C.

2. Verfahren nach Anspruch 1, wobei flaches Implantieren mit einer Implantationsenergie bei oder unter 5 keV durchgeführt wird.

3. Verfahren nach einem der Ansprüche 1 oder 2, wobei mindestens eines des Folgenden zutrifft
- flaches Implantieren des Dotierstoffs umfasst Implantieren des Dotierstoffs in das Halbleitermaterial (2) mit breiter Bandlücke unter Verwendung einer Dosis zwischen 10¹⁴/cm² und 10¹⁸/cm²;
- das Halbleitermaterial mit breiter Bandlücke umfasst Siliziumcarbid;
- das aufgebrachte Metallmaterial bildet mindestens eine Kontaktmetallschicht (33) aus, ohne in dem mindestens einen Grenzbereich (5) chemisch mit dem Halbleitermaterial (2) mit breiter Bandlücke zu reagieren; oder
- der mindestens eine ohmsche Kontaktbereich (3), der durch das abgelagerte Metallmaterial ausgebildet wurde, ist dicker als der mindestens eine Grenzbereich (5).

4. Verfahren nach einem der Ansprüche 1 bis 3, weiterhin mindestens eines des Folgenden umfassend:
- Durchführen einer frontseitigen Verarbeitung des Halbleiterbauelements (1) mit breiter Bandlücke vor Ausbilden mindestens eines des mindestens einen Grenzbereichs (5) oder des mindestens einen ohmschen Kontaktbereichs (3); oder
- Ausbilden mindestens einer Oxidschicht oder einer Passivierungsschicht (58) vor dem Aufbringen des Metallmaterials.

5. Verfahren nach einem der Ansprüche 1 bis 4, weiterhin mindestens eines des Folgenden umfassend:
- Durchführen einer rückseitigen Verarbeitung des Halbleiterbauelements (1) mit breiter Bandlücke, wobei die rückseitige Verarbeitung einen thermischen Behandlungsschritt umfasst, der zu der thermischen Behandlung des Grenzbereichs (5) führt; oder
- Ausbilden mindestens eines rückseitigen Kontakts auf einer zweiten Oberfläche des Halbleiterbauelements (1), wobei Ausbilden des mindestens einen rückseitigen Kontakts einen Temperschritt umfasst, der zu der thermischen Behandlung des Grenzbereichs (5) führt.

6. Verfahren nach einem der Ansprüche 1 bis 5, weiterhin Folgendes umfassend:
- Ausbilden mindestens einer Grabenstruktur (14) innerhalb des Halbleitermaterials (2) mit breiter Bandlücke oder Ausbilden einer frontseitigen Struktur (57) auf der ersten Oberfläche (4); und
- Verwenden der mindestens einen Grabenstruktur (14) oder der frontseitigen Struktur (57), um den mindestens einen Grenzbereich (5) und/oder den mindestens einen ohmschen Kontaktbereich (3) lateral selbst auszurichten.

7. Verfahren nach einem der Ansprüche 1 bis 6, weiterhin Folgendes umfassend:
- Ätzen des Halbleitermaterials (2) mit breiter Bandlücke, um mindestens eine Aussparung (35) auszubilden, wobei mindestens einer des mindestens einen ohmschen Kontaktbereichs (3) oder einer frontseitigen Elektrodenschicht (34), die auf einer dritten Oberfläche des mindestens einen Kontaktbereichs (3) ausgebildet ist, als eine Ätzmaske dient.

8. Halbleiterbauelement (1) mit breiter Bandlücke, Folgendes umfassend:
- einen Halbleiterkörper oder eine Epitaxie-Schicht, die ein Halbleitermaterial (2) mit breiter Bandlücke umfasst;
- mindestens einen Grenzbereich (5), der dotiert ist und innerhalb einer flachen Implantationsschicht des Halbleitermaterials (2) mit breiter Bandlücke angeordnet ist, wobei der mindestens eine Grenzbereich (5) eine erste Dicke (T₁) unter 50 nm aufweist; und
- mindestens einen ohmschen Kontaktbereich (3), der mehr als 99 % Metallmaterial umfasst, das innerhalb einer Kontaktschicht auf der Oberseite des mindestens einen Grenzbereichs (5) angeordnet ist, wobei der mindestens eine ohmsche Kontaktbereich (3) eine zweite Dicke (T₂) aufweist, die größer ist als die erste Dicke (T₁); **dadurch gekennzeichnet, dass** ein distinkter Peak in der Sauerstoff-(O)-Konzentration an der Oberseite des Grenzbereichs (5) beobachtet werden kann.

9. Halbleiterbauelement (1) mit breiter Bandlücke nach Anspruch 8, weiterhin mindestens einen aktiven Bereich umfassend, der innerhalb des Halbleitermaterials (2) mit breiter Bandlücke angeordnet ist, wobei der mindestens eine aktive Bereich eine dritte Dicke aufweist, wobei mindestens eines des Folgenden zutrifft
- die dritte Dicke ist größer als mindestens eine der ersten Dicke (T₁) oder der zweiten Dicke (T₂); oder
- der mindestens eine dotierte Grenzbereich (5) weist eine höhere Dotierstoffkonzentration auf als der mindestens eine aktive Bereich; oder
- ein Dotierstoffmaterial des mindestens einen aktiven Bereichs unterscheidet sich von einem Dotierstoffmaterial des mindestens einen Grenzbereichs (5).

10. Halbleiterbauelement (1) mit breiter Bandlücke nach Anspruch 8 oder 9, wobei das Halbleiterbauelement (1) mit breiter Bandlücke ein Grabenbauelement ist, das eine Grabenstruktur (14) umfasst, und der mindestens eine Grenzbereich (5) und der mindestens eine ohmsche Kontaktbereich (3) lateral benachbart zu der mindestens einen Grabenstruktur (14) sind.

11. Halbleiterbauelement (1) mit breiter Bandlücke nach Anspruch 10, wobei die mindestens eine Grabenstruktur (14) ein vergrabenes Gate (16), einen Isolationsbereich (17), der auf der Oberseite des vergrabenen Gates (16) angeordnet ist, und mindestens eine vertikale Passivierungsschicht (18) umfasst, die lateral zwischen dem Isolationsbereich (17) und dem mindestens einen Grenzbereich (5) angeordnet ist.

12. Halbleiterbauelement (1) mit breiter Bandlücke nach Anspruch 8 oder 9, wobei das Halbleiterbauelement (1) mit breiter Bandlücke ein planares Bauelement ist, das mindestens eine frontseitige Struktur (57) umfasst, die in einer Schicht (55) über dem Halbleiterkörper oder der Epitaxie-Schicht angeordnet ist, und wobei der mindestens eine Grenzbereich (5) und der mindestens eine ohmsche Kontaktbereich (3) lateral benachbart zu der mindestens einen frontseitigen Struktur (57) sind.

13. Halbleiterbauelement (1) mit breiter Bandlücke nach Anspruch 12, wobei die mindestens eine frontseitige Struktur ein Metall-Gate (59) und eine Gate-Isolation (60) umfasst, wobei die Gate-Isolation (60) einen horizontalen Isolationsbereich, der auf einer oberen Oberfläche des Metall-Gates (59) angeordnet ist, und einen vertikalen Isolationsbereich umfasst, der auf mindestens einer seitlichen Oberfläche des Metall-Gates (59) angeordnet ist, wobei der mindestens eine vertikale Isolationsbereich lateral zwischen dem Metall-Gate (59) und mindestens einem ohmschen Kontaktbereich (3) angeordnet ist.

14. Halbleiterbauelement (1) mit breiter Bandlücke nach einem der Ansprüche 8 bis 13, wobei mindestens eines des Folgenden zutrifft
- das Halbleitermaterial (2) mit breiter Bandlücke umfasst ein Siliziumcarbid-Material eines Siliziumcarbid-Wafers oder einer Epitaxie-Siliziumcarbid-Schicht; oder
- der mindestens eine Grenzbereich (5) umfasst mindestens eines von implantierten Phosphor-Ionen, implantierten Bor-Ionen, implantierten Arsen-Ionen, implantierten Antimon-Ionen und implantierten Aluminium-Ionen; oder
- der mindestens eine ohmsche Kontaktbereich (3) umfasst mindestens eines von Nickel, Titan, Aluminium, Platin, Palladium, Kobalt, Wolfram, Wolframcarbid, Titannitrid, Titancarbid, Tantal, Tantalcarbid oder Molybdän.

15. Halbleiterbauelement (1) mit breiter Bandlücke nach einem der Ansprüche 8 bis 14, wobei das Halbleiterbauelement (1) ein Leistungshalbleiterbauelement ist, das eines umfasst von einer Sperrschicht-Schottky-Diode, einem metallisolierten Halbleiter-Feldeffekttransistor, einem Metalloxid-Halbleiter-Feldeffekttransistor (50), einem Bipolartransistor mit isoliertem Gate, einem Sperrschicht-Gate-Feldeffekttransistor, einem Bipolartransistor oder einem Akkumulations-Feldeffekttransistor (10).

## Revendications

1. Procédé destiné à former un contact ohmique sur un dispositif semi-conducteur à large bande interdite (1), comprenant :
- l'implantation superficielle d'un dopant à travers une première surface (4) du dispositif semi-conducteur à large bande interdite (1) au moyen d'une énergie d'implantation de moins de 15 keV pour former au moins une région d'interface (5) dans un matériau semi-conducteur à large bande interdite (2) ;
- le traitement thermique rapide de l'au moins une région d'interface (5) comprenant le dopant implanté à une température inférieure à 1100 °C ;
- après le traitement thermique rapide de l'au moins une région d'interface (5), le dépôt d'un matériau métallique au-dessus de l'au moins une région d'interface (5) pour former au moins une région de contact ohmique (3) ; et
- éventuellement, le recuit du matériau métallique déposé à une température de recuit inférieure à 700 °C.

2. Procédé de la revendication 1, dans lequel l'implantation superficielle est réalisée avec une énergie d'implantation égale ou inférieure à 5 keV.

3. Procédé de l'une quelconque des revendications 1 et 2, dans lequel au moins une des situations suivantes s'applique :
- l'implantation superficielle du dopant comprend l'implantation du dopant à l'intérieur du matériau semi-conducteur à large bande interdite (2) au moyen d'une dose comprise entre 10¹⁴/cm² et 10¹⁸/cm² ;
- le matériau semi-conducteur à large bande interdite comprend du carbure de silicium ;
- le matériau métallique déposé forme au moins une couche métallique de contact (33) sans réagir chimiquement avec le matériau semi-conducteur à large bande interdite (2) dans l'au moins une région d'interface (5) ; ou
- l'au moins une région de contact ohmique (3) formée par le matériau métallique déposé est plus épaisse que l'au moins une région d'interface (5).

4. Procédé de l'une quelconque des revendications 1 à 3, comprenant en outre au moins une des opérations suivantes :
- réalisation d'un traitement de la face avant du dispositif semi-conducteur à large bande interdite (1) avant la formation de l'au moins une région d'interface (5) et/ou de l'au moins une région de contact ohmique (3) ; ou
- formation d'une couche d'oxyde et/ou d'une couche de passivation (58) avant le dépôt du matériau métallique.

5. Procédé de l'une quelconque des revendications 1 à 4, comprenant en outre au moins une des opérations suivantes :
- réalisation d'un traitement de la face arrière du dispositif semi-conducteur à large bande interdite (1), le traitement de la face arrière comportant une étape de traitement thermique, qui se solde par le traitement thermique de la région d'interface (5) ; ou
- formation d'au moins un contact arrière sur une deuxième surface du dispositif semi-conducteur (1), la formation de l'au moins un contact arrière comportant une étape de recuit, qui se solde par le traitement thermique de la région d'interface (5).

6. Procédé de l'une quelconque des revendications 1 à 5, comprenant en outre :
- la formation d'au moins une structure de tranchée (14) à l'intérieur du matériau semi-conducteur à large bande interdite (2) ou la formation d'une structure avant (57) sur la première surface (4) ; et
- l'utilisation de l'au moins une structure de tranchée (14) ou de la structure avant (57), respectivement, pour auto-aligner latéralement l'au moins une région d'interface (5) et/ou l'au moins une région de contact ohmique (3).

7. Procédé de l'une quelconque des revendications 1 à 6, comprenant en outre :
- la gravure du matériau semi-conducteur à large bande interdite (2) pour former au moins une encoche (35), l'au moins une région de contact ohmique (3) et/ou une couche d'électrode avant (34) formée sur une troisième surface de l'au moins une région de contact (3) servant de masque de gravure.

8. Dispositif semi-conducteur à large bande interdite (1), comprenant :
- un corps semi-conducteur ou une couche épitaxiale comprenant un matériau semi-conducteur à large bande interdite (2) ;
- au moins une région d'interface (5), qui est dopée et disposée à l'intérieur d'une couche d'implantation superficielle du matériau semi-conducteur à large bande interdite (2), l'au moins une région d'interface (5) possédant une première épaisseur (T₁) inférieure à 50 nm ; et
- au moins une région de contact ohmique (3) comprenant plus de 99 % de matériau métallique disposée à l'intérieur d'une couche de contact au-dessus de l'au moins une région d'interface (5), l'au moins une région de contact ohmique (3) possédant une deuxième épaisseur (T₂) supérieure à la première épaisseur (T₁) ; **caractérisé en ce qu'**un pic distinct de la concentration en oxygène (0-) peut être observé au sommet de la région d'interface (5).

9. Dispositif semi-conducteur à large bande interdite (1) de la revendication 8, comprenant en outre au moins une région active disposée à l'intérieur du matériau semi-conducteur à large bande interdite (2), l'au moins une région active possédant une troisième épaisseur, au moins une des situations suivantes s'appliquant :
- la troisième épaisseur est supérieure à la première épaisseur (T₁) et/ou à la deuxième épaisseur (T₂) ; ou
- l'au moins une région d'interface dopée (5) présente une plus forte concentration de dopant que l'au moins une région active ; ou
- un matériau dopant de l'au moins une région active diffère d'un matériau dopant de l'au moins une région d'interface (5).

10. Dispositif semi-conducteur à large bande interdite (1) de la revendication 8 ou 9, le dispositif semi-conducteur à large bande interdite (1) étant un dispositif à tranchée comprenant une structure de tranchée (14), et l'au moins une région d'interface (5) et l'au moins une région de contact ohmique (3) étant latéralement adjacentes à l'au moins une structure de tranchée (14).

11. Dispositif semi-conducteur à large bande interdite (1) de la revendication 10, dans lequel l'au moins une structure de tranchée (14) comprend une grille enterrée (16), une zone d'isolation (17) disposée au-dessus de la grille enterrée (16), et au moins une couche de passivation verticale (18) disposée latéralement entre la zone d'isolation (17) et l'au moins une région d'interface (5).

12. Dispositif semi-conducteur à large bande interdite (1) de la revendication 8 ou 9, le dispositif semi-conducteur à large bande interdite (1) étant un dispositif plan comprenant au moins une structure avant (57) disposée dans une couche (55) au-dessus du corps semi-conducteur ou de la couche épitaxiale, et l'au moins une région d'interface (5) et l'au moins une région de contact ohmique (3) étant latéralement adjacentes à l'au moins une structure avant (57).

13. Dispositif semi-conducteur à large bande interdite (1) de la revendication 12, dans lequel l'au moins une structure avant comprend une grille métallique (59) et une isolation de grille (60), l'isolation de grille (60) comprenant une zone d'isolation horizontale disposée sur une surface supérieure de la grille métallique (59) et une zone d'isolation verticale disposée sur au moins une surface latérale de la grille métallique (59), l'au moins une zone d'isolation verticale étant disposée latéralement entre la grille métallique (59) et au moins une région de contact ohmique (3).

14. Dispositif semi-conducteur à large bande interdite (1) de l'une quelconque des revendications 8 à 13, dans lequel au moins une des situations suivantes s'appliquer :
- le matériau semi-conducteur à large bande interdite (2) comprend un matériau en carbure de silicium d'une tranche en carbure de silicium ou d'une couche épitaxiale en carbure de silicium ; ou
- l'au moins une région d'interface (5) comprend des ions luminophores implantés, et/ou des ions bore implantés, et/ou des ions arsenic implantés, et/ou des ions antimoine implantés, et/ou des ions aluminium implantés ; ou
- l'au moins une région de contact ohmique (3) comprend au moins un matériau parmi le nickel, le titane, l'aluminium, le platine, le palladium, le cobalt, le tungstène, le carbure de tungstène, le nitrure de titane, le carbure de titane, le tantale, le carbure de tantale et le molybdène.

15. Dispositif semi-conducteur à large bande interdite (1) de l'une quelconque des revendications 8 à 14, le dispositif semi-conducteur (1) étant un dispositif semi-conducteur de puissance, comprenant un composant parmi une diode Schottky à barrière de jonction, un transistor à effet de champ métal-isolant-semi-conducteur, un transistor à effet de champ métal-oxyde-semi-conducteur (50), un transistor bipolaire à grille isolée, un transistor à effet de champ à grille de jonction, un transistor à jonction bipolaire, et un transistor à effet de champ à accumulation (10).
